# EUROPEAN PATENT APPLICATION

(11) **EP 2 555 264 A1**
(43) Date of publication of application: **06.02.2013**
(21) Application number: 11762430.4
(22) Date of filing: 25.02.2011
(51) Int. Cl.: H01L 33/60, F21S 2/00, F21V 29/00, H01L 33/62, F21Y 101/02

(54) **LIGHT EMITTING ELEMENT MODULE SUBSTRATE, LIGHT EMITTING ELEMENT MODULE, AND ILLUMINATING DEVICE**

(30) Priority: 31.03.2010 JP 2010081911
(71) Applicant: Kabushiki Kaisha Toshiba, Minato-ku Tokyo 105-8001 (JP); Toshiba Lighting&Technology Corporation, Yokosuka-shi, Kanagawa 237-8510 (JP)
(72) Inventor: HAPPOYA, Akihiko, Tokyo 105-8001 (JP); IZUMI, Masahiro, Yokosuka-shi Kanagawa 237-8510 (JP); SANPEI, Tomohiro, Yokosuka-shi Kanagawa 237-8510 (JP)
(74) Representative: HOFFMANN EITLE
(86) International application number: PCT/JP2011/054321
(87) International publication number: WO 2011/122190

(57) **Abstract**

According to an aspect of the invention, there is provided a light emitting element module substrate including: a laminated plate; and a metal layer. The laminated plate includes a base metal plate and an insulating layer provided on the base metal plate. The metal layer is provided on the insulating layer. The metal layer includes a mounting section on which a light emitting element is to be mounted, and a bonding section to which a wiring electrically connected to the light emitting element is to be bonded. The metal layer includes a silver layer which is an uppermost layer of at least one of the mounting section and the bonding section and is formed by electrolytic plating. The mounting section and the bonding section are electrically isolated from a periphery of the laminated plate.

## Description

### [Technical Field]

This invention relates to a light emitting element module substrate, a light emitting element module, and an illuminating device.

### [Background Art]

Semiconductor light emitting elements such as LED (light emitting diode) are used for illumination. For instance, there is an illumination using a light emitting element module of the COB (chip on board) type in which an LED element is directly mounted on a substrate. For instance, Patent Document 1 discloses a light emitting device including a substrate, a plurality of light emitting elements placed on the substrate, and a phosphor layer.

In a light emitting element such as LED, the light emission efficiency decreases at high temperatures. In order to increase heat dissipation and to obtain high light emission efficiency, there is a configuration in which a laminated plate of a metal plate and an insulating layer provided thereon is used as a substrate. The thickness of this insulating layer is set to a certain value or less in order to increase thermal conductivity between the LED element and the metal plate.

On the insulating layer of the laminated plate is provided a metal layer including a mounting section with the LED element mounted thereon, and a bonding section for electrical connection of the LED element. This metal layer is required to have high bonding performance as well as high reflectance.

On the other hand, if this metal layer extends on the end portion of the substrate (laminated plate), insulation between the metal plate of the laminated plate and the metal layer is degraded in the end portion of the substrate because the insulating layer is thin. Then, the desired operation cannot be achieved.

Thus, the mounting section and the bonding section using the metal layer are required to be electrically insulated from the end portion of the substrate as well as having high reflectance and high bonding performance.

### [Citation List]

### [Patent Literature]

### [PTL 1]

JP-A 2009-111273(Kokai)

### [Summary of Invention]

### [Technical Problem]

The invention provides a light emitting element module substrate, a light emitting element module, and an illuminating device including a mounting section and a bonding section having high reflectance and high bonding performance and being superior in electrical insulation from the end portion.

### [Solution to Problem]

According to an aspect of the invention, there is provided a light emitting element module substrate including: a laminated plate; and a metal layer. The laminated plate includes a base metal plate and an insulating layer provided on the base metal plate. The metal layer is provided on the insulating layer. The metal layer includes a mounting section on which a light emitting element is to be mounted, and a bonding section to which a wiring electrically connected to the light emitting element is to be bonded. The metal layer includes a silver layer which is an uppermost layer of at least one of the mounting section and the bonding section and is formed by electrolytic plating. The mounting section and the bonding section are electrically isolated from a periphery of the laminated plate.

According to another aspect of the invention, there is provided a light emitting element module substrate including: a laminated plate; and a metal layer. The laminated plate includes a base metal plate and an insulating layer provided on the base metal plate. The metal layer is provided on the insulating layer. The metal layer includes a mounting section on which a light emitting element is to be mounted, and a bonding section to which a wiring electrically connected to the light emitting element is to be bonded. The metal layer includes a silver layer which is an uppermost layer of at least one of the mounting section and the bonding section and has a thickness of 1 micrometer or more. The mounting section and the bonding section are electrically isolated from a periphery of the laminated plate.

According to another aspect of the invention, there is provided a light emitting element module including: one of above-mentioned light emitting element module substrates: a light emitting element mounted on the mounting section of the light emitting element module substrate; and a wiring electrically connecting the light emitting element and the bonding section.

According to another aspect of the invention, there is provided an illuminating device including: the above-mentioned light emitting element module; and a heat dissipation member thermally connected to the base metal plate.

### [Advantageous Effects of Invention]

The embodiments provide a light emitting element module substrate, a light emitting element module, and an illuminating device including a mounting section and a bonding section having high reflectance and high bonding performance and being superior in electrical insulation from the end portion.

### [Brief Description of Drawings]

[Fig. 1]

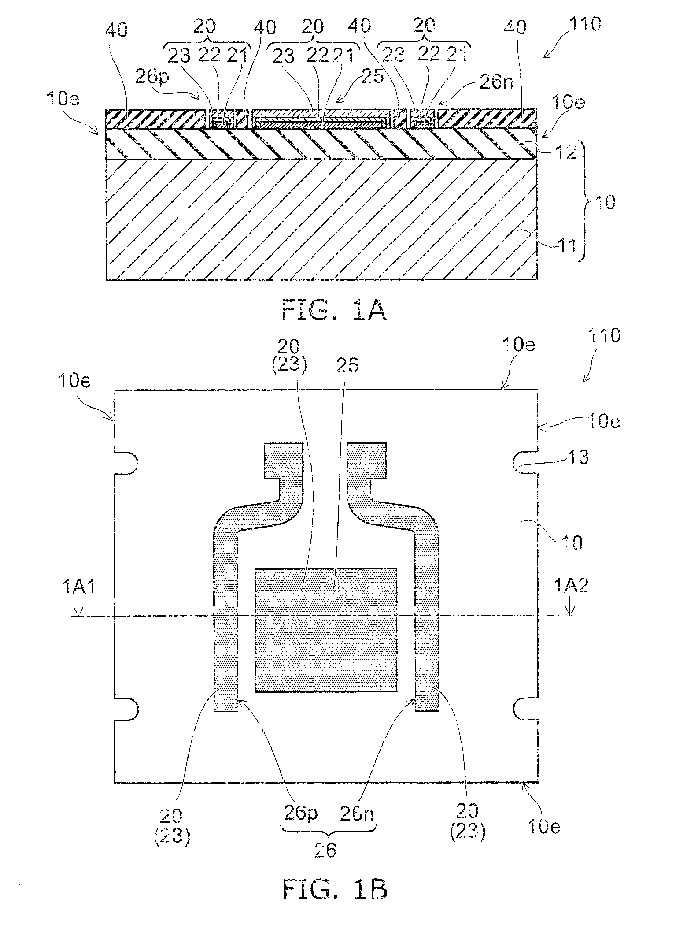

   FIGS. 1A and 1B are schematic views illustrating the configuration of a light emitting element module substrate according to a first embodiment.
[Fig. 2]

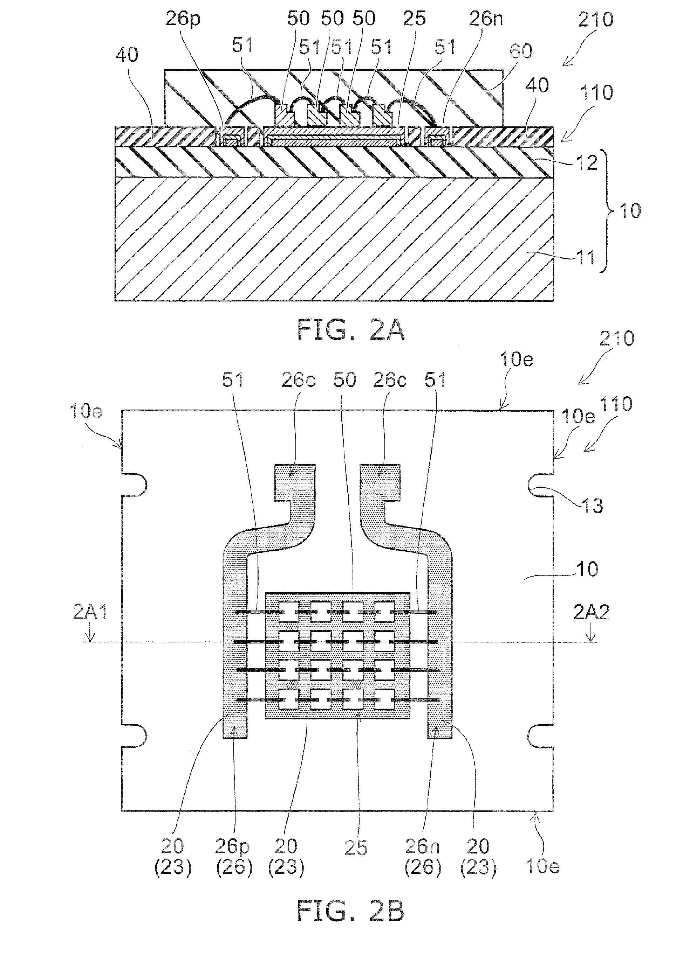

   FIGS. 2A and 2B are schematic views illustrating the usage state of the light emitting element module substrate according to the first embodiment.
[Fig. 3]

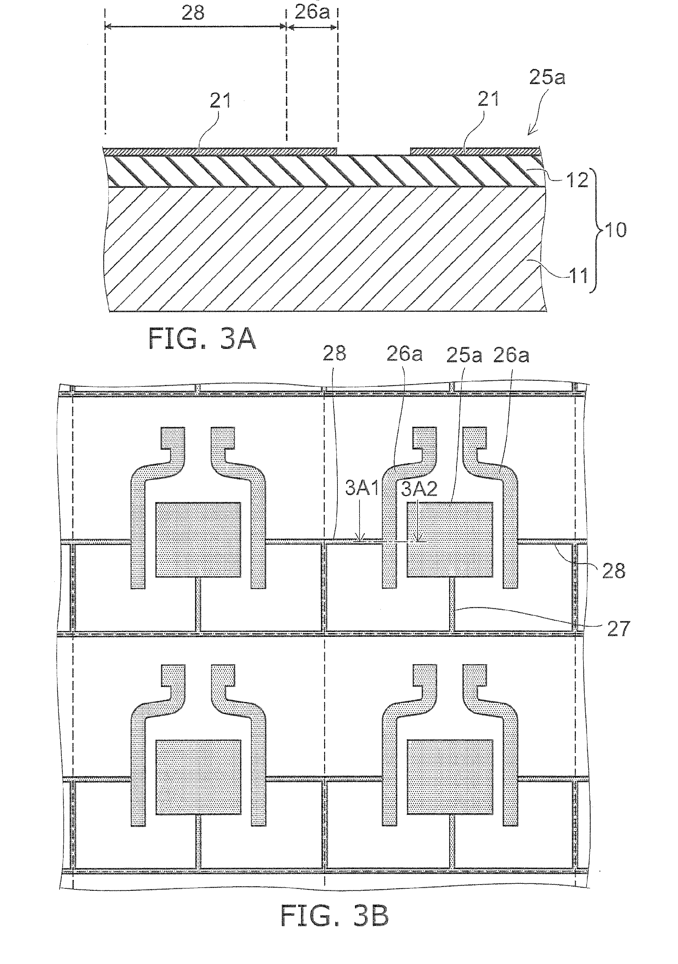

   FIGS. 3A and 3B are sequential schematic views illustrating a method for manufacturing the light emitting element module substrate according to the first embodiment.
[Fig. 4]

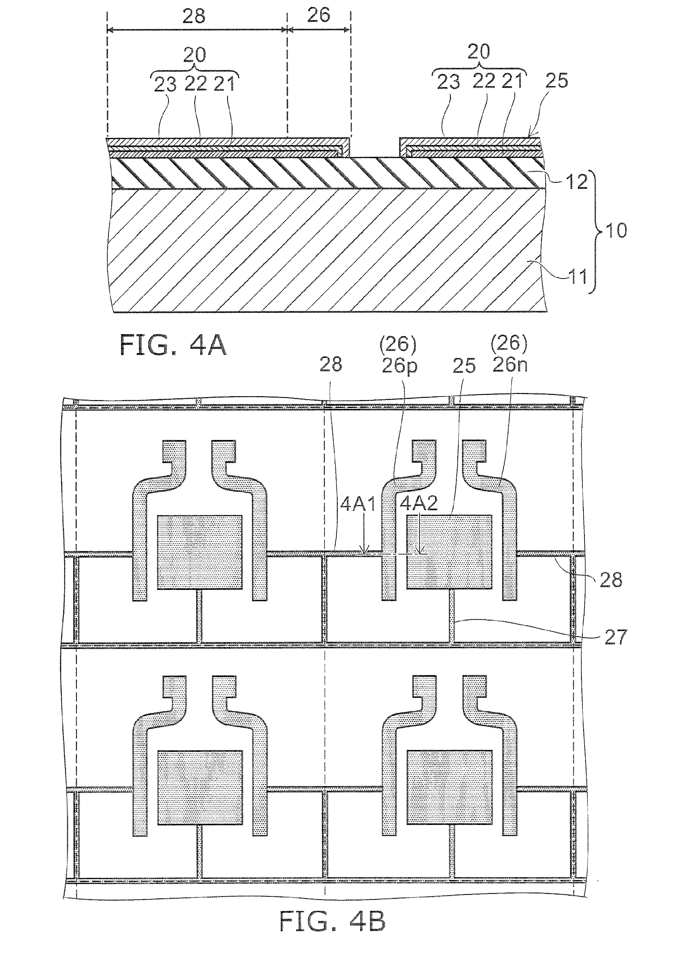

   FIGS. 4A and 4B are sequential schematic views illustrating a method for manufacturing the light emitting element module substrate according to the first embodiment.
[Fig. 5]

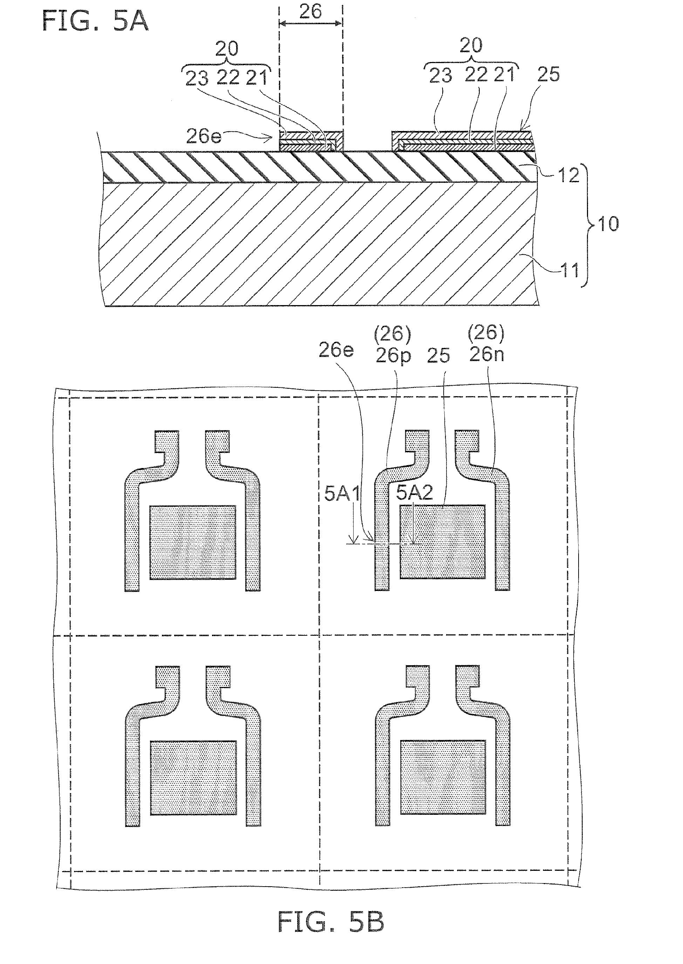

   FIGS. 5A and 5B are sequential schematic views illustrating a method for manufacturing the light emitting element module substrate according to the first embodiment.
[Fig. 6]

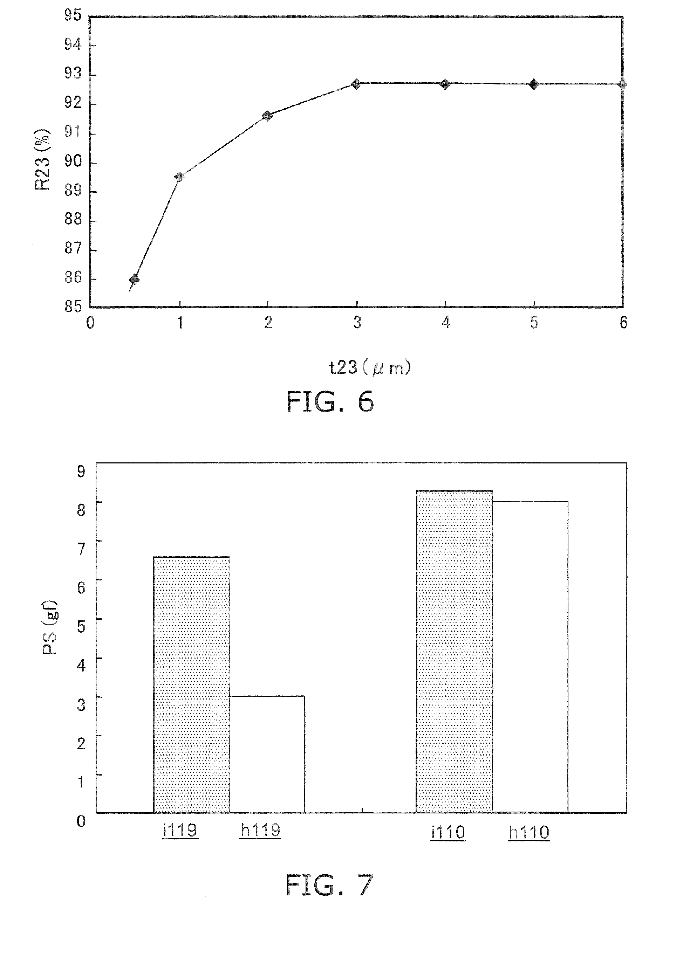

   FIG. 6 is a graph illustrating the characteristics of the light emitting element module substrate according to the first embodiment.
[Fig. 7]
   FIG. 7 is a graph illustrating the characteristics of the light emitting element module substrate according to the first embodiment.
[Fig. 8]

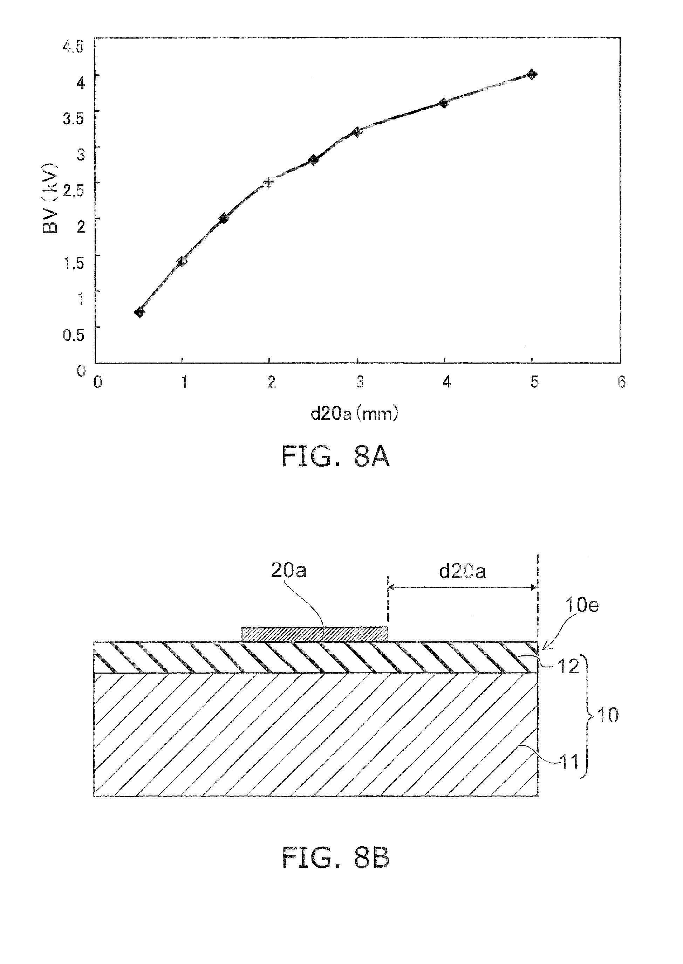

   FIGS. 8A and 8B illustrate the characteristics of the light emitting element module substrate according to the first embodiment.
[Fig. 9]

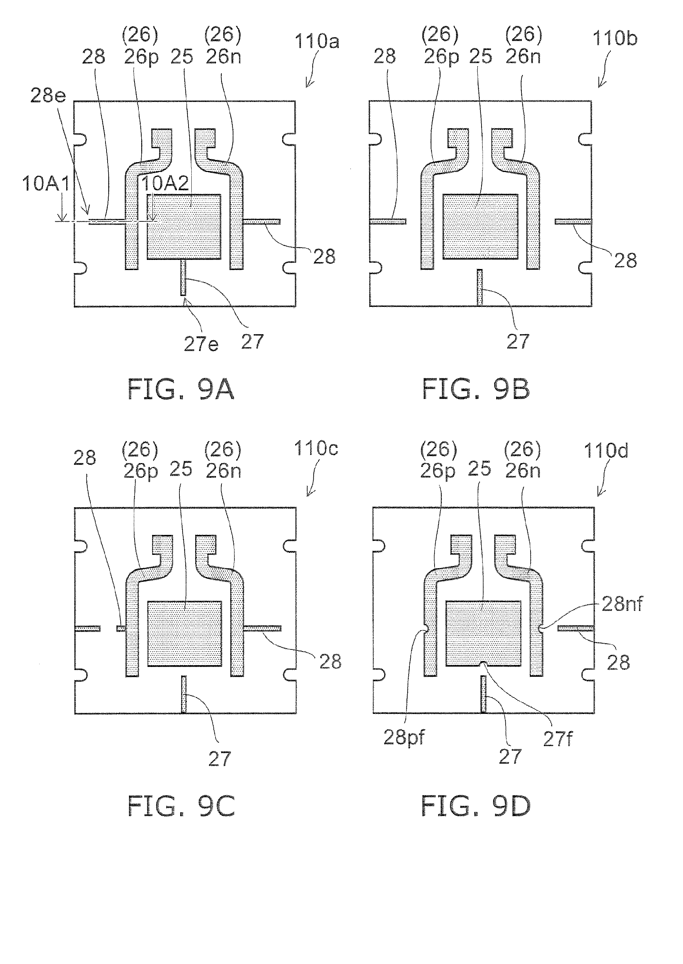

   FIGS. 9A to 9D are schematic plan views illustrating the configuration of alternative light emitting element module substrates according to the first embodiment.
[Fig. 10]

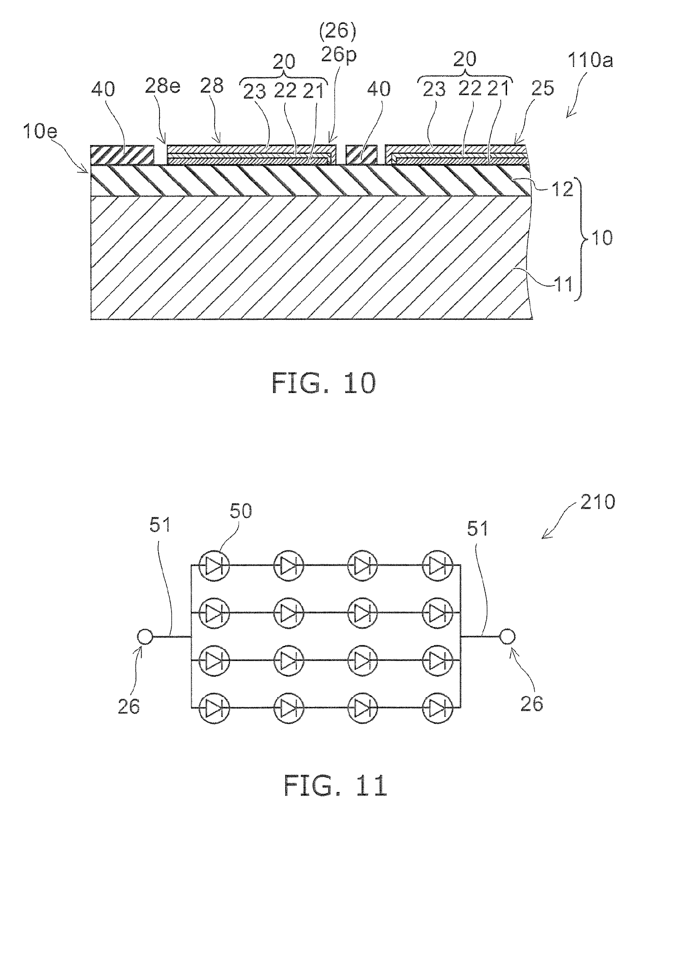

   FIG. 10 is a schematic sectional view illustrating the configuration of the alternative light emitting element module substrate according to the first embodiment.
[Fig. 11]
   FIG. 11 is a circuit diagram illustrating the configuration of the light emitting element module according to the second embodiment.
[Fig. 12]

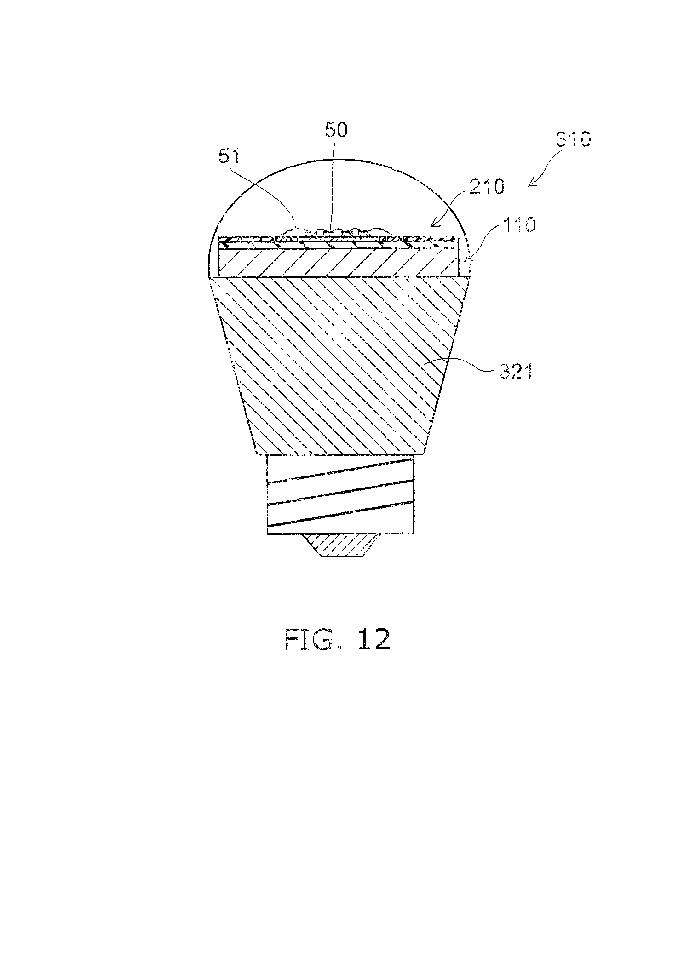

   FIG. 12 is a schematic sectional view illustrating the configuration of an illuminating device according to a third embodiment.

### [Description of Embodiments]

Embodiments will now be described with reference to the drawings.
The drawings are schematic or conceptual. The relationship between the thickness and the width of each portion, and the size ratio between the portions, for instance, are not necessarily identical to those in reality. Furthermore, the same portion may be shown with different dimensions or ratios depending on the figures.
In the present specification and the drawings, components similar to those described previously with reference to earlier figures are labeled with like reference numerals, and the detailed description thereof is omitted appropriately.

### (First embodiment)

FIGS. 1A and 1B are schematic views illustrating the configuration of a light emitting element module substrate according to a first embodiment.
More specifically, FIG. 1B is a schematic plan view illustrating the configuration of the light emitting element module substrate 110 according to this embodiment. FIG. 1A is a schematic sectional view illustrating the configuration of the light emitting element module substrate 110, being a sectional view taken along line 1A1-1A2 of FIG. 1B.

As shown in FIGS. 1A and 1B, the light emitting element module substrate 110 includes a laminated plate 10 and a metal layer 20.

The laminated plate 10 includes a base metal plate 11 and an insulating layer 12 provided on the base metal plate 11.

The base metal plate 11 is made of e.g. aluminum, copper, and iron, and an alloy containing two or more thereof. That is, the base metal plate 11 is made of a metal having high thermal conductivity to improve heat dissipation of the light emitting element module substrate 110. The thickness of the base metal plate 11 can be set to e.g. approximately 0.5 mm or more and approximately 2 mm or less. Preferably, the thickness of the base metal plate 11 is set to e.g. approximately 1 mm or more and approximately 1.5 mm or less. However, this embodiment is not limited thereto. The thickness of the base metal plate 11 is arbitrary.

The insulating layer 12 can be made of e.g. a resin such as epoxy, phenol, cyanate, and polyimide resin. The insulating layer 12 can also be made of e.g. a thermosetting resin including e.g. bismaleimide triazine resin.
The insulating layer 12 may also be made of e.g. glass cloth impregnated with these resins. The insulating layer 12 may also be made of e.g. these resins added with a filler.

That is, in order to increase heat dissipation of the light emitting element module substrate 110, the thermal resistance of the insulating layer 12 is set to be low. The thermal resistance of the insulating layer 12 is reduced by using such a technique as thinning the insulating layer 12 and increasing the thermal conductivity of the insulating layer 12.
In order to obtain good thermal conductivity, the thickness of the insulating layer 12 is set to e.g. 150 micrometers (µm) or less.

The metal layer 20 is provided on the insulating layer 12. The metal layer 20 includes a mounting section 25 on which a light emitting element is to be mounted, and a bonding section 26 to which a wiring electrically connected to the light emitting element is to be bonded. The bonding section 26 can include e.g. an n-side bonding section 26n and a p-side bonding section 26p.

In this example, one mounting section 25 is provided, one n-side bonding section 26n is provided, and one p-side bonding section 26p is provided. However, the number of mounting sections 25 and bonding sections 26 (e.g., n-side bonding sections 26n and p-side bonding sections 26p) is arbitrary. Furthermore, the pattern shape of the mounting section 25 and the pattern shape of the bonding section 26 (e.g., n-side bonding section 26n and p-side bonding section 26p) are arbitrary. Furthermore, the n-side bonding section 26n and the p-side bonding section 26p are interchangeable.
The light emitting element is e.g. a semiconductor light emitting element such as LED element.

The metal layer 20 includes a silver layer 23 constituting the uppermost layer of at least one of the mounting section 25 and the bonding section 26. In this example, the silver layer 23 constitutes the uppermost layer of both the mounting section 25 and the bonding section 26.

The metal layer 20 further includes an underlying layer 21 provided between the silver layer 23 and the insulating layer 12. The metal layer 20 can further include an intermediate layer 22 provided between the underlying layer 21 and the silver layer 23. That is, in this example, the metal layer 20 has a stacked structure of the underlying layer 21, the intermediate layer 22 provided thereon, and the silver layer 23 provided thereon and constituting the uppermost layer of the metal layer 20.

The underlying layer 21 can contain e.g. copper (Cu). That is, the underlying layer 21 can be a Cu layer. However, this embodiment is not limited thereto. The material used for the underlying layer 21 is arbitrary.

The intermediate layer 22 can contain at least one of nickel (Ni) and palladium (Pd). That is, the intermediate layer 22 can be one of a Ni layer, a Pd layer, and a layer containing Ni and Pd. However, this embodiment is not limited thereto. The material used for the intermediate layer 22 is arbitrary.

The silver layer 23 is formed by e.g. electrolytic plating.
That is, the underlying layer 21 is used as an electrode layer for electrolytic plating. The intermediate layer 22 functions as a barrier layer. The intermediate layer 22 thus provided suppresses that e.g. a component (e.g., Cu) of the material used for the underlying layer 21 migrates to the surface side during long-term operation. The intermediate layer 22 is provided as necessary, and can be omitted as the case may be.

In the case where the silver layer 23 is formed by electrolytic plating, the intermediate layer 22 can be a Ni layer formed by electrolytic plating. In this case, the intermediate layer 22 is composed primarily of Ni, and the intermediate layer 22 does not substantially contain phosphorus (P).

In the case where the silver layer 23 is formed by electroless plating, and the intermediate layer 22 is a Ni layer formed by electroless plating, then the intermediate layer 22 contains phosphorus besides Ni. For instance, the ratio of phosphorus in the intermediate layer 22 is approximately 8% or more and 10% or less (the ratio of Ni is approximately 90% or more and 82% or less). This is because the formation of a Ni layer by electroless plating is based on the deposition phenomenon of plating coating by the reducing action of hypophosphorous acid.

The thickness of the silver layer 23 is e.g. 1 µm or more. This enables the silver layer 23 to have high reflectance and high bonding performance as described later. That is, in this embodiment, the metal layer 20 can have high reflectance and high bonding performance.

The mounting section 25 and the bonding section 26 are electrically isolated from the periphery 10e of the laminated plate 10. Specifically, the mounting section 25 and the bonding section 26 are spaced from the periphery 10e of the laminated plate 10. The distance from the periphery 10e of the laminated plate 10 to the mounting section 25 and the bonding section 26 is set to a distance sufficient for electrical isolation.

As shown in FIG. 1A, in this example, a solder resist layer 40 is provided on the portion of the upper surface of the insulating layer 12 where the metal layer 20 is not provided. The solder resist layer 40 is made of e.g. a white material. This enables the solder resist layer 40 to efficiently reflect the emission light of the light emitting element described later, and increases the efficiency.

FIGS. 2A and 2B are schematic views illustrating the usage state of the light emitting element module substrate according to the first embodiment.
More specifically, these figures illustrate the state in which LED elements are mounted on the light emitting element module substrate 110 to form a light emitting element module 210. That is, FIG. 2B is a schematic plan view illustrating the configuration of the light emitting element module 210. FIG. 2A is a schematic sectional view illustrating the configuration of the light emitting element module 210, being a sectional view taken along line 2A1-2A2 of FIG. 2B.

As illustrated in FIGS. 2A and 2B, the light emitting element module 210 includes the light emitting element module substrate 110 according to this embodiment, a light emitting element 50 mounted on the mounting section 25 of the light emitting element module substrate 110, and a bonding wiring 51 (wiring) for electrically connecting the light emitting element 50 and the bonding section 26.

The light emitting element 50 is e.g. an LED element. In this example, a plurality of light emitting elements 50 are used. However, the number of light emitting elements 50 is arbitrary. Each light emitting element 50 includes e.g. a p-side electrode and an n-side electrode, not shown. The n-side electrode is electrically connected to e.g. the n-side bonding section 26n or the p-side electrode of another light emitting element 50 by a bonding wiring 51. The p-side electrode is electrically connected to e.g. the p-side bonding section 26p or the n-side electrode of another light emitting element 50 by a bonding wiring 51.

In this example, the metal layer 20 is further provided with a power supply section 26c in electrical continuity with the bonding section 26. To the power supply section 26c, for instance, an external connector is attached. Alternatively, to the power supply section 26c, an external power supply wiring is connected by such a technique as soldering. Thus, the light emitting element 50 is supplied with electrical power from outside the light emitting element module substrate 110, and the light emitting element 50 is caused to emit light.

In this example, the light emitting element module substrate 110 is provided with an attachment section 13. By the attachment section 13, the light emitting element module substrate 110 is attached to the heat dissipation member of the illuminating device described later using such a technique as screwing.

The light emitting element module 210 can further include a wavelength conversion layer 60 covering at least part of the light emitting element 50. The wavelength conversion layer 60 absorbs emission light emitted from the light emitting element 50 and emits light having a wavelength different from the wavelength of the emission light. The wavelength conversion layer 60 can be e.g. a phosphor layer.

Part of the emission light emitted from the light emitting element 50 travels to the upper surface side (the opposite side from the laminated plate 10) of the light emitting element 50 and passes through the wavelength conversion layer 60 where the wavelength is converted. Thus, the light is extracted to the outside of the light emitting element module 210.

Another part of the emission light emitted from the light emitting element 50 travels to the lower surface side (the laminated plate 10 side) of the light emitting element 50. The light is reflected by the metal layer 20, travels toward the wavelength conversion layer 60, and passes through the wavelength conversion layer 60 where the wavelength is converted. Thus, the light is extracted to the outside of the light emitting element module 210.

In the light emitting element module 210, a silver layer 23 is provided as the uppermost layer of the metal layer 20. Thus, the emission light emitted from the light emitting element 50 is efficiently reflected by the metal layer 20. Thus, the light emission efficiency is high.

Furthermore, the silver layer 23 used as the uppermost layer of the metal layer 20 provides good bonding performance between the bonding section 26 and the bonding wiring 51.

Furthermore, the mounting section 25 and the bonding section 26 are electrically isolated from the periphery 10e of the laminated plate 10. Thus, the mounting section 25 and the bonding section 26 are sufficiently electrically insulated from the end portion.
As described above, the light emitting element module substrate 110 can provide a light emitting element module substrate including a mounting section and a bonding section having high reflectance and high bonding performance and being superior in electrical insulation from the end portion.

FIGS. 3A, 3B, 4A, 4B, 5A, and 5B are sequential schematic views illustrating a method for manufacturing the light emitting element module substrate according to the first embodiment.
More specifically, FIG. 3B is a schematic plan view illustrating one step of the method for manufacturing the light emitting element module substrate 110. FIG. 3A is a sectional view taken along line 3A1-3A2 of FIG. 3B.
FIG. 4B is a schematic plan view illustrating a step subsequent to the step illustrated in FIGS. 3A and 3B. FIG. 4A is a sectional view taken along line 4A1-4A2 of FIG. 4B.
FIG. 5B is a schematic plan view illustrating a step subsequent to the step illustrated in FIGS. 4A and 4B. FIG. 5A is a sectional view taken along line 5A1-5A2 of FIG. 5B.
In this example, the silver layer 23 is formed by electrolytic plating. In these figures, the solder resist layer 40 is not shown.

As shown in FIGS. 3A and 3B, on the insulating layer 12 of a laminated plate 10, an underlying layer 21 having a prescribed shape is formed. The underlying layer 21 includes a portion 25a corresponding to the mounting section 25 and a portion 26a corresponding to the bonding section 26. The underlying layer 21 further includes a mounting section plating wiring section 27 for performing electrolytic plating on the portion 25a corresponding to the mounting section 25, and a bonding section plating wiring section 28 for performing electrolytic plating on the portion 26a corresponding to the bonding section 26.

In this example, a laminated plate having a large area is used. A metal layer is formed thereon in a pattern in which a plurality of final light emitting element module substrates 110 are arranged. Then, the metal layer and the laminated plate are divided to collectively manufacture a plurality of light emitting element module substrates 110. However, this embodiment is not limited thereto. A method for separately forming light emitting element module substrates 110 one by one may also be adopted.

Then, as shown in FIGS. 4A and 4B, on the underlying layer 21, an intermediate layer 22 is formed by electrolytic plating. Furthermore, on the intermediate layer 22, a silver layer 23 is formed by electrolytic plating. Thus, the mounting section 25 and the bonding section 26 of the metal layer 20 are formed. As described above, as the case may be, the intermediate layer 22 may be omitted. In this case, the silver layer 23 is formed on the underlying layer 21 by electrolytic plating.

In this step, the intermediate layer 22 is formed so as to cover the upper surface and side surface of the underlying layer 21. Furthermore, the silver layer 23 is formed so as to cover the upper surface and side surface of the intermediate layer 22. As described above, as the case may be, the intermediate layer 22 may be omitted. In this case, the silver layer 23 is formed so as to cover the upper surface and side surface of the underlying layer 21.

Furthermore, for instance, the intermediate layer 22 and the silver layer 23 are formed also on the mounting section plating wiring section 27 and the bonding section plating wiring section 28 of the underlying layer 21. As described above, as the case may be, the intermediate layer 22 may be omitted. In this case, the silver layer 23 is formed on the mounting section plating wiring section 27 and the bonding section plating wiring section 28 of the underlying layer 21.

Then, as shown in FIGS. 5A and 5B, for instance, by etching using a mask, the mounting section plating wiring section 27 and the bonding section plating wiring section 28 are removed. That is, the underlying layer 21, the intermediate layer 22, and the silver layer 23 corresponding to the mounting section plating wiring section 27 are removed. The underlying layer 21, the intermediate layer 22, and the silver layer 23 corresponding to the bonding section plating wiring section 28 are removed.

In this step, at the end surface (end portion 26e) of the portion of the metal layer 20 which was connected to the mounting section plating wiring section 27 and the bonding section plating wiring section 28 thus removed, the underlying layer 21 and the intermediate layer 22 are exposed.

That is, in the metal layer 20, at least part of the plating wiring section used for electrolytic plating is removed. At the side surface (in this example, the aforementioned end portion 26e) of at least part of the metal layer 20, the underlying layer 21 is exposed. In the case where the intermediate layer 22 is provided, at the side surface of at least part of the metal layer 20, the underlying layer 21 and the intermediate layer 22 are exposed.

Then, the laminated plate 10 is cut in a prescribed size. Furthermore, as necessary, an attachment section 13 is formed. Thus, the light emitting element module substrate 110 is fabricated.

As described above, in the light emitting element module substrate 110 according to this embodiment, the silver layer 23 constituting the uppermost layer of the metal layer 20 is formed by electrolytic plating. In the metal layer 20, at least part of the plating wiring section (mounting section plating wiring section 27 and bonding section plating wiring section 28) used for electrolytic plating is removed.
Thus, the mounting section 25 and the bonding section 26 are electrically isolated from the periphery 10e of the laminated plate 10.

In the following, the characteristics of the light emitting element module substrate 110 according to this embodiment are described. More specifically, the characteristics of the metal layer 20, and particularly of the silver layer 23 thereof, are described.

FIG. 6 is a graph illustrating the characteristics of the light emitting element module substrate according to the first embodiment.
More specifically, this figure illustrates a measurement result of the relationship between the thickness t23 and the reflectance R23 of the silver layer 23. The horizontal axis represents the thickness t23 of the silver layer 23. The vertical axis represents the reflectance R23 of the silver layer 23 for a wavelength of 460 nanometers (nm). In this example, a Ni plating layer having a thickness of 5 µm is provided below the silver layer 23.

As shown in FIG. 6, for instance, if the thickness t23 of the silver layer 23 is as small as 0.5 µm, then the reflectance R23 is 86%. Thus, the reflectance R23 is low. With the increase of the thickness t23, the reflectance R23 increases. For instance, for a thickness t23 of 1 µm, the reflectance R23 increases to 89.5%. For a thickness t23 of 2 µm, the reflectance R23 further increases to 91.6%. When the thickness t23 further increases to 3 µm or more, the reflectance R23 becomes constant at approximately 93%.

As the reflectance R23 becomes higher, the light extraction efficiency increases. Thus, it is preferable that the thickness t23 of the silver layer 23 be thick. Preferably, the thickness t23 of the silver layer 23 is 1 µm or more. This achieves high reflectance R23. More preferably, the thickness t23 of the silver layer 23 is 2 µm or more. This achieves higher reflectance R23. More preferably, the thickness t23 of the silver layer 23 is 3 µm or more. This achieves higher and stable reflectance R23.

Here, as a method for forming the silver layer 23, it is also considered to use electroless plating. However, the thickness t23 of the silver layer 23 based on electroless plating is less than 1 µm, such as approximately 0.5 µm or less. Thus, in the light emitting element module substrate 110 according to this embodiment, in order to obtain a thickness of 1 µm or more, electrolytic plating is adopted in the formation of the silver layer 23.

FIG. 7 is a graph illustrating the characteristics of the light emitting element module substrate according to the first embodiment.
More specifically, this figure illustrates a measurement result of the bonding characteristics in the case where the thickness t23 of the silver layer 23 is 0.5 µm and 2.0 µm. The vertical axis represents the wire pull strength PS (gf). This figure illustrates the wire pull strength PS in the initial state i119 and the state h119 after heating treatment at 180°C for 60 minutes in the case where the thickness t23 of the silver layer 23 is 0.5 µm, and the initial state i110 and the state h110 after heat treatment at 180°C for 60 minutes in the case where the thickness t23 of the silver layer 23 is 2 µm. Here, the case where the thickness t23 of the silver layer 23 is 0.5 µm corresponds to a comparative example. The case where the thickness t23 of the silver layer 23 is 2 µm corresponds to an example of this embodiment. Also in this case, a Ni plating layer having a thickness of 5 µm is provided below the silver layer 23.

As shown in FIG. 7, in the initial state i119 in the case where the thickness t23 of the silver layer 23 is 0.5 µm, the wire pull strength PS is as small as approximately 6.5 gf. In the state h119 after heat treatment, the wire pull strength PS significantly decreases to approximately 3 gf.

On the other hand, in the initial state i110 in the case where the thickness t23 of the silver layer 23 is 2 µm, the wire pull strength PS is approximately 8.2 gf, higher than that for a thickness t23 of 0.5 µm. In the state h110 after heat treatment in the case where the thickness t23 of the silver layer 23 is 2 µm, the wire pull strength PS is approximately 8.0 gf, nearly comparable to that in the initial state i110. The decrease of wire pull strength due to heat treatment is much smaller than that in the comparative example.

Thus, in the comparative example in which the thickness t23 of the silver layer 23 is 0.5 µm, the wire pull strength PS is small, and is significantly decreased by heat treatment. In contrast, in the embodiment in which the thickness t23 of the silver layer 23 is 2 µm, the wire pull strength PS is very large, and its decrease due to heat treatment is suppressed.

Thus, if the thickness t23 of the silver layer 23 is thick, the wire pull strength PS increases and improves the bonding performance. Hence, preferably, the thickness t23 of the silver layer 23 is 1 µm or more. This achieves high bonding performance. More preferably, the thickness t23 of the silver layer 23 is 2 µm or more. This achieves higher bonding performance.

FIGS. 8A and 8B illustrate the characteristics of the light emitting element module substrate according to the first embodiment.
More specifically, FIG. 8A illustrates a measurement result of the breakdown voltage for different distances between the conductive layer 20a provided on the insulating layer 12 of the laminated plate 10 and the end of the laminated plate 10. FIG. 8B is a schematic sectional view illustrating the condition of the above measurement.

As shown in FIG. 8B, the laminated plate 10 includes a base metal plate 11 and an insulating layer 12 laminated thereon. In this measurement, the thickness of the base metal plate 11 is 1 mm, and the thickness of the insulating layer 12 is 80 µm. On the insulating layer 12, a conductive layer 20a is provided. The conductive layer 20a corresponds to the metal layer 20. In this measurement, the conductive layer 20a is a copper layer having a thickness of 35 µm. With the distance d20a between the conductive layer 20a and the end (periphery 10e) of the laminated plate 10 varied, the breakdown voltage BV was measured. The breakdown voltage BV is a breakdown voltage with respect to alternating current.

FIG. 8A is a graph illustrating the measurement result of the breakdown voltage BV. The horizontal axis represents the distance d20a between the conductive layer 20a and the end (periphery 10e) of the laminated plate 10. The vertical axis represents the breakdown voltage BV.

As shown in FIG. 8A, with the increase of the distance d20a between the conductive layer 20a and the end (periphery 10e) of the laminated plate 10, the breakdown voltage BV increases. For instance, for a distance d20a of 1 mm, the breakdown voltage BV is approximately 1.4 kilovolts (kV). For a distance d20a of 2 mm, the breakdown voltage BV is approximately 2.5 kV. For a distance d20a of 3 mm, the breakdown voltage BV is approximately 3.2 kV.

Here, the breakdown voltage BV depends also on e.g. the thickness of the insulating layer 12. In general, if the thickness of the insulating layer 12 becomes thick, the breakdown voltage BV increases. However, in general, if the thickness of the insulating layer 12 becomes thick, the thermal conductivity of the laminated plate 10 decreases, and the heat dissipation decreases. Thus, the thickness of the insulating layer 12 is set to an appropriate value in consideration of heat dissipation.

For instance, as described above, in order to increase the heat dissipation of the light emitting element module substrate 110, the insulating layer 12 can be made of a resin added with a filler.
Typically, the thermal conductivity of a resin is approximately 0.2 W/mK. Thus, the insulating layer 12 can be made of a resin added with a filler having high thermal conductivity such as alumina and BN. This can achieve a thermal conductivity of e.g. approximately 1 W/mK or more and 6 W/mK or less.

If the insulating layer 12 is thinned, and the concentration of the filler is set to be high, then the thermal resistance of the insulating layer 12 decreases. However, accordingly, the breakdown voltage of the light emitting element module substrate 110 tends to decrease. Thus, in order to achieve the breakdown voltage performance required for application to illuminating devices, the specification of the insulating layer 12 is appropriately specified in consideration of the breakdown voltage performance and the heat dissipation performance.

The aforementioned distance d20a is appropriately specified so as to achieve a necessary breakdown voltage BF adapted to the thickness of the specified thickness of the insulating layer 12.

In the light emitting element module substrate 110 according to this embodiment, the mounting section 25 and the bonding section 26 are electrically isolated from the periphery 10e of the laminated plate 10. That is, the mounting section 25 and the bonding section 26 are spaced from the periphery 10e. The end, on the side of the periphery 10e of the laminated plate 10, of the conductive layer electrically connected to the mounting section 25 and the bonding section 26 is spaced from the periphery 10e. The distance between this end of the conductive layer on the periphery 10e side and the periphery 10e is specified based on e.g. the relationship between the distance d20a and the breakdown voltage BV illustrated in FIG. 8A.

As described above, in the light emitting element module substrate 110 according to this embodiment, the silver layer 23 of the metal layer 20 is set to a thickness of 1 µm or more (preferably 2 µm or more). This achieves high reflectance and high bonding performance. Such a thick silver layer 23 can be formed by the electrolytic plating method. At least part of the plating wiring section (mounting section plating wiring section 27 and bonding section plating wiring section 28) used for this electrolytic plating is removed. Accordingly, the mounting section 25 and the bonding section 26 are sufficiently electrically isolated from the end portion (periphery 10e) of the laminated plate 10.

Thus, the mounting section 25 and the bonding section 26 are electrically isolated from the end portion (periphery 10e) of the laminated plate 10. This achieves a breakdown voltage BV of e.g. 1 kV or more.

In the light emitting element module substrate 110 according to this embodiment, the pattern shape of the metal layer 20 is arbitrary as long as the mounting section 25 and the bonding section 26 are electrically isolated from the periphery 10e of the laminated plate 10.

FIGS. 9A to 9D are schematic plan views illustrating the configuration of alternative light emitting element module substrates according to the first embodiment.
As shown in FIGS. 9A to 9D, in the alternative light emitting element module substrates 110a-110d according to this embodiment, at least part of the plating wiring section (mounting section plating wiring section 27 and bonding section plating wiring section 28) used for electrolytic plating is removed.

More specifically, in the light emitting element module substrate 110a illustrated in FIG. 9A, a portion of the plating wiring section on the periphery 10e side is removed. The inside portion of the plating wiring section remains. The rest is similar to the light emitting element module substrate 110, and hence the description thereof is omitted.

In the light emitting element module substrate 110a, the end portion (the end portion 27e of the mounting section plating wiring section 27 and the end portion 28e of the bonding section plating wiring section 28), on the side of the periphery 10e of the laminated plate 10, of the remaining part of the plating wiring section is sufficiently spaced from the periphery 10e. Thus, the mounting section 25 and the bonding section 26 are electrically isolated from the periphery 10e of the laminated plate 10.

In the light emitting element module substrate 110b illustrated in FIG. 9B, an inside portion of the plating wiring section far from the periphery 10e is removed. Thus, the plating wiring section is divided midway. The outside portion (on the periphery 10e side) of the plating wiring section remains. The rest is similar to the light emitting element module substrate 110, and hence the description thereof is omitted.

Also in the light emitting element module substrate 110b, the plating wiring section is divided. Thus, the mounting section 25 and the bonding section 26 are electrically isolated from the plating wiring section. Accordingly, the mounting section 25 and the bonding section 26 are electrically isolated from the periphery 10e of the laminated plate 10.

In the light emitting element module substrate 110c illustrated in FIG. 9C, an inside portion of the mounting section plating wiring section 27 far from the periphery 10e is removed. Thus, the plating wiring section is divided midway. In the bonding section plating wiring section 28 connected to the n-side bonding section 26n, a portion on the periphery 10e side is removed. In the bonding section plating wiring section 28 connected to the p-side bonding section 26p, a midway portion between the periphery 10e and the inside portion is removed.

Also in the light emitting element module substrate 110c, the plating wiring section is divided. Thus, the mounting section 25 and the bonding section 26 are electrically isolated from the plating wiring section. Accordingly, the mounting section 25 and the bonding section 26 are electrically isolated from the periphery 10e of the laminated plate 10.
Thus, in the metal layer 20, the removed portion of the plating wiring section used for electrolytic plating is arbitrary.

In the light emitting element module substrate 110d illustrated in FIG. 9D, in the mounting section 25, the portion 27f connected to the mounting section plating wiring section 27 is removed. Thus, the mounting section plating wiring section 27 and the mounting section 25 are divided. Furthermore, in the n-side bonding section 26n, the portion 28nf connected to the bonding section plating wiring section 28 is removed. Thus, the bonding section plating wiring section 28 and the n-side bonding section 26n are divided. Furthermore, the bonding section plating wiring section 28 connected to the p-side bonding section 26p is removed. Moreover, in the p-side bonding section 26p, the portion 28pf connected to the bonding section plating wiring section 28 is removed. Thus, in at least one of the mounting section 25 and the bonding section 26, the portion connected to the plating wiring section may be removed.

Also in the light emitting element module substrate 110d, the plating wiring section is divided from the mounting section 25 and the bonding section 26. Thus, the plating wiring section is electrically isolated from the mounting section 25 and the bonding section 26. Accordingly, the mounting section 25 and the bonding section 26 are electrically isolated from the periphery 10e of the laminated plate 10.

Thus, the removed portion of the plating wiring section used for electrolytic plating is arbitrary. Furthermore, in the mounting section 25 and the bonding section 26, the position and shape of the removed portion connected to the plating wiring section are arbitrary.

The light emitting element module substrates 110a-110d can also provide a light emitting element module substrate including a mounting section 25 and a bonding section 26 having high reflectance and high bonding performance and being superior in electrical insulation from the end portion.

FIG. 10 is a schematic sectional view illustrating the configuration of the alternative light emitting element module substrate according to the first embodiment.
More specifically, FIG. 10 is a sectional view taken along line 10A1-10A2 of FIG. 9A.

As shown in FIG. 10, in the light emitting element module substrate 110a, a portion of the plating wiring section (e.g., bonding section plating wiring section 28) on the periphery 10e side is removed. The inside portion of the plating wiring section (e.g., bonding section plating wiring section 28) remains. In the remaining portion of the plating wiring section, the underlying layer 21 is exposed at the end portion (e.g., the end portion 28e of the bonding section plating wiring section 28) on the side of the periphery 10e of the laminated plate 10. In this example, the intermediate layer 22 is provided. In the remaining portion of the plating wiring section, the underlying layer 21 and the intermediate layer 22 are exposed at the end portion (e.g., the end portion 28e of the bonding section plating wiring section 28) on the side of the periphery 10e of the laminated plate 10.

Likewise, although not shown, in the remaining portion of the plating wiring section, the underlying layer 21 is exposed at the end portion (e.g., the end portion 27e of the mounting section plating wiring section 27) on the side of the periphery 10e of the laminated plate 10. In this example, the underlying layer 21 and the intermediate layer 22 are exposed.

Thus, in the light emitting element module substrate 110a, the underlying layer 21 is exposed at the side surface of at least part of the metal layer 20.
Likewise, also in the light emitting element module substrates 110b-110d, the underlying layer 21 is exposed at the side surface of at least part of the metal layer 20.

Thus, in this embodiment, the silver layer 23 is formed by electrolytic plating. In the metal layer 20, at least part of the plating wiring section used for electrolytic plating is removed after the electrolytic plating. Accordingly, the underlying layer 21 is exposed at the side surface of at least part of the metal layer 20.

In the case where the silver layer 23 is formed by such a technique as electroless plating, the plating wiring section is not provided. Thus, the upper surface and side surface of the underlying layer 21 are covered with the intermediate layer 22, and the upper surface and side surface of the intermediate layer 22 are covered with the silver layer 23. Accordingly, at the side surface of the metal layer 20, the underlying layer 21 is not exposed.

### (Second embodiment)

The second embodiment is a light emitting element module 210 using the light emitting element module substrate 110 according to the embodiment.
The configuration of the light emitting element module 210 according to this embodiment is as described above with reference to FIGS. 2A and 2B. That is, the light emitting element module 210 includes one of the light emitting element module substrates (e.g., at least one of the light emitting element module substrates 110, 110a-110d) according to the embodiment. In the following description, it is assumed that the light emitting element module substrate 110 is used.

As described with reference to FIGS. 2A and 2B, the light emitting element module 210 further includes a light emitting element 50 mounted on the mounting section 25 of the light emitting element module substrate 110, and a bonding wiring 51 for electrically connecting the light emitting element 50 and the bonding section 26.

The light emitting element 50 is e.g. an LED element based on nitride semiconductor.
The bonding wiring 51 is made of e.g. one of gold, silver, aluminum, and copper, and an alloy containing two or more thereof.

FIG. 11 is a circuit diagram illustrating the configuration of the light emitting element module according to the second embodiment.
As shown in FIG. 11, in the light emitting element module 210 according to this embodiment, a plurality of light emitting elements 50 are series and parallel connected by the bonding wiring 51. In this example, 16 light emitting elements 50 are used, and a 4 series 4 parallel circuit configuration is applied thereto. However, this embodiment is not limited thereto. The number of light emitting elements 50 and the applied circuit configuration are arbitrary.

As described with reference to FIGS. 2A and 2B, the light emitting element module 210 can further include a wavelength conversion layer 60 covering at least part of the light emitting element 50. The wavelength conversion layer 60 absorbs emission light emitted from the light emitting element 50 and emits light having a wavelength different from the wavelength of the emission light. The wavelength conversion layer 60 is formed by such a method as coating.
Thus, for instance, white light is obtained. However, this embodiment is not limited thereto. The wavelength conversion layer 60 is provided as necessary, and may be omitted.

For instance, a method for obtaining white light emission in an illuminating device (including e.g. backlight) using e.g. LED elements is to use three kinds of light emitting elements 50 (e.g., LED elements) emitting e.g. blue, green, and red light. This method may be applied to the light emitting element module 210.

Another method for obtaining white light emission is to combine e.g. a blue emitting light emitting element 50 (e.g., LED element) with at least one of yellow and orange emitting phosphors. This method may be applied to the light emitting element module 210.

Another method for obtaining white light emission is to combine e.g. an ultraviolet emitting light emitting element 50 (LED element) with three kinds of phosphors emitting blue, green, and red light. This method may be applied to the light emitting element module 210.
As described above, in the case of using phosphor, the wavelength conversion layer 60 is provided.

In an illumination using LED elements, depending on the required light flux, for instance, a plurality of LED elements are mounted on the light emitting element module substrate. The method for mounting an LED element on the light emitting element module substrate can be e.g. the method of mounting a package including an LED element on the light emitting element module substrate by e.g. soldering, and the method of mounting an LED element chip on the light emitting element module substrate directly by wire bonding (COB configuration).

In the light emitting element module 210 according to this embodiment, the COB configuration is adopted. Thus, higher brightness can be achieved with higher density than the former technique. In the light emitting element module 210, on the plurality of light emitting elements 50 (LED elements) mounted on the light emitting element module substrate 110, a resin mixed with phosphor is applied to provide a wavelength conversion layer 60. Thus, for instance, illumination with a desired color temperature is realized. Furthermore, besides white color, light with an arbitrary color is obtained.

In an LED element, part of the inputted electrical energy is converted to light energy, and another part is consumed as heat. This increases the temperature of the LED element during operation. If the temperature of the LED element increases, for instance, degradation of the LED element proceeds, and shortens its lifetime. Furthermore, as described above, the LED element exhibits high light emission efficiency at low temperatures, and the light emission efficiency decreases at high temperatures. Thus, in an illuminating device using LED elements, countermeasures against heat are important. In the light emitting element module substrate 110, sufficiently high heat dissipation is required.

In the light emitting element module substrate 110 and the light emitting element module 210 based thereon according to the embodiments, the base metal plate 11 is used in the laminated plate 10 on which the light emitting element 50 is mounted. Thus, high heat dissipation is achieved. This can achieve high light emission efficiency and favorable lifetime.

In the light emitting element module 210, sufficient performance concerning basic insulation is required in view of preventing the destruction of the LED element by surge and other voltage, and ensuring the safety of products. For instance, in an illuminating device using the light emitting element module 210, for instance, after assembling the illuminating device, the breakdown voltage is applied to the lighting circuit being a charged section, and to the device body being a non-charged section. By checking whether the device can sufficiently withstand this voltage, the performance concerning basic insulation is evaluated. Here, the value of the breakdown voltage varies with the input voltage of the illuminating device. As the input voltage becomes higher, basic insulation against higher breakdown voltage is required. For instance, in the illuminating device using the light emitting element module 210, typically, a breakdown voltage of 1 kV or more is required.

In the light emitting element module substrate 110 and the light emitting element module 210 according to the embodiments, the mounting section 25 and the bonding section 26 are electrically isolated from the periphery 10e of the laminated plate 10. Thus, a breakdown voltage of 1 kV or more can be achieved.

### (Third embodiment)

FIG. 12 is a schematic sectional view illustrating the configuration of an illuminating device according to a third embodiment.
As shown in FIG. 12, the illuminating device 310 according to this embodiment includes the light emitting element module 210 according to the embodiment, and a heat dissipation member 321 thermally connected to the base metal plate 11 of the light emitting element module substrate 110 included in the light emitting element module 210.
The heat dissipation member 321 is made of e.g. an aluminum die-cast metal material.

Here, the base metal plate 11 (laminated plate 10) can be attached to the heat dissipation member 321 by such a method as screwing using the attachment section 13. However, this embodiment is not limited thereto. The method of attachment is arbitrary. In this embodiment, the heat dissipation member 321 and the base metal plate 11 are thermally connected. Thus, heat generated in the light emitting element 50 is efficiently transferred to the heat dissipation member 321 through the base metal plate 11. Accordingly, high heat dissipation is achieved.

The illuminating device of this example is an illuminating device shaped like a light bulb. However, the shape of the illuminating device is arbitrary. For instance, such shapes as downlight and MiniKrypton can also be adopted. Furthermore, for instance, this example is also applicable to such illuminating devices as backlights and head lamps.

The illuminating device 310 according to this embodiment adopts the light emitting element module 210 using the light emitting element module substrate 110 according to the embodiment. This can realize a mounting section and a bonding section having high reflectance and high bonding performance and being superior in electrical insulation from the end portion. Thus, an illuminating device having high efficiency, low power consumption, high reliability, and high operational stability can be realized.

The embodiments of the invention have been described above with reference to examples. However, the invention is not limited to these examples. For instance, any specific configurations of various components such as the laminated plate, base metal plate, insulating layer, metal layer, silver layer, underlying layer, intermediate layer, plating wiring section, and solder resist layer included in the light emitting element module substrate, such as the light emitting element, wiring, and wavelength conversion layer included in the light emitting element module, and such as the heat dissipation member included in the illuminating device can be variously modified in shape, size, material, layout and the like by those skilled in the art. Such modifications are encompassed within the scope of the invention as long as those skilled in the art can similarly practice the invention and achieve similar effects by suitably selecting such configurations from conventionally known ones.
Further, any two or more components of the specific examples may be combined within the extent of technical feasibility and are included in the scope of the invention to the extent that the purport of the invention is included.

Moreover, all light emitting element module substrates, light emitting element modules, and illuminating devices practicable by an appropriate design modification by one skilled in the art based on the all light emitting element modules substrate, light emitting element modules, and illuminating devices described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.
While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A light emitting element module substrate comprising:
a laminated plate including a base metal plate and an insulating layer provided on the base metal plate; and
a metal layer provided on the insulating layer and including a mounting section on which a light emitting element is to be mounted, and a bonding section to which a wiring electrically connected to the light emitting element is to be bonded,
the metal layer including a silver layer, the silver layer being an uppermost layer of at least one of the mounting section and the bonding section and being formed by electrolytic plating, and
the mounting section and the bonding section being electrically isolated from a periphery of the laminated plate.

2. The substrate according to claim 1, wherein in the metal layer, at least part of a plating wiring section used for the electrolytic plating is removed.

3. The substrate according to claim 1, wherein the metal layer further includes an underlying layer provided between the silver layer and the insulating layer.

4. The substrate according to claim 3, wherein the metal layer further includes an intermediate layer provided between the underlying layer and the silver layer.

5. The substrate according to claim 4, wherein
the underlying layer contains copper, and
the intermediate layer contains nickel.

6. The substrate according to claim 5, wherein the intermediate layer does not substantially contain phosphorus.

7. The substrate according to claim 3, wherein the underlying layer is exposed at a side surface of at least part of the metal layer.

8. The substrate according to claim 1, further comprising:
a light reflective insulating layer provided on a portion of an upper surface of the insulating layer where the metal layer is not provided.

9. The substrate according to claim 1, wherein the silver layer has a thickness of 1 micrometer or more.

10. A light emitting element module substrate comprising:
a laminated plate including a base metal plate and an insulating layer provided on the base metal plate; and
a metal layer provided on the insulating layer and including a mounting section on which a light emitting element is to be mounted, and a bonding section to which a wiring electrically connected to the light emitting element is to be bonded,
the metal layer including a silver layer, the silver layer being an uppermost layer of at least one of the mounting section and the bonding section and having a thickness of 1 micrometer or more, and
the mounting section and the bonding section being electrically isolated from a periphery of the laminated plate.

11. The substrate according to claim 10, wherein the metal layer further includes an underlying layer provided between the silver layer and the insulating layer.

12. The substrate according to claim 11, wherein the metal layer further includes an intermediate layer provided between the underlying layer and the silver layer.

13. The substrate according to claim 12, wherein
the underlying layer contains copper, and
the intermediate layer contains nickel.

14. The substrate according to claim 13, wherein the intermediate layer does not substantially contain phosphorus.

15. The substrate according to claim 11, wherein the underlying layer is exposed at a side surface of at least part of the metal layer.

16. The substrate according to claim 10, further comprising:
a light reflective insulating layer provided on a portion of an upper surface of the insulating layer where the metal layer is not provided.

17. A light emitting element module comprising:
a light emitting element module substrate including:
a laminated plate including a base metal plate and an insulating layer provided on the base metal plate; and
a metal layer provided on the insulating layer and including a mounting section on which a light emitting element is to be mounted, and a bonding section to which a wiring electrically connected to the light emitting element is to be bonded;
a light emitting element mounted on the mounting section of the light emitting element module substrate; and
a wiring electrically connecting the light emitting element and the bonding section,
the metal layer including a silver layer, the silver layer being an uppermost layer of at least one of the mounting section and the bonding section and being formed by electrolytic plating, and
the mounting section and the bonding section being electrically isolated from a periphery of the laminated plate.

18. An illuminating device comprising:
a light emitting element module including:
a light emitting element module substrate including:
a laminated plate including a base metal plate and an insulating layer provided on the base metal plate;
and
a metal layer provided on the insulating layer and including a mounting section on which a light emitting element is to be mounted, and a bonding section to which a wiring electrically connected to the light emitting element is to be bonded;
a light emitting element mounted on the mounting section of the light emitting element module substrate; and
a wiring electrically connecting the light emitting element and the bonding section; and
a heat dissipation member thermally connected to the base metal plate,
the metal layer including a silver layer, the silver layer being an uppermost layer of at least one of the mounting section and the bonding section and being formed by electrolytic plating, and
the mounting section and the bonding section being electrically isolated from a periphery of the laminated plate.

19. A light emitting element module comprising:
a light emitting element module substrate including:
a laminated plate including a base metal plate and an insulating layer provided on the base metal plate; and
a metal layer provided on the insulating layer and including a mounting section on which a light emitting element is to be mounted, and a bonding section to which a wiring electrically connected to the light emitting element is to be bonded;
a light emitting element mounted on the mounting section of the light emitting element module substrate; and
a wiring electrically connecting the light emitting element and the bonding section,
the metal layer including a silver layer, the silver layer being an uppermost layer of at least one of the mounting section and the bonding section and having a thickness of 1 micrometer or more, and
the mounting section and the bonding section being electrically isolated from a periphery of the laminated plate.

20. An illuminating device comprising:
a light emitting element module including:
a light emitting element module substrate including:
a laminated plate including a base metal plate and an insulating layer provided on the base metal plate;
and
a metal layer provided on the insulating layer and including a mounting section on which a light emitting element is to be mounted, and a bonding section to which a wiring electrically connected to the light emitting element is to be bonded;
a light emitting element mounted on the mounting section of the light emitting element module substrate; and
a wiring electrically connecting the light emitting element and the bonding section; and
a heat dissipation member thermally connected to the base metal plate,
the metal layer including a silver layer, the silver layer being an uppermost layer of at least one of the mounting section and the bonding section and having a thickness of 1 micrometer or more, and
the mounting section and the bonding section being electrically isolated from a periphery of the laminated plate.
